# EUROPEAN PATENT SPECIFICATION

(11) **EP 3 936 476 B1**
(45) Date of publication and mention of the grant of the patent: **29.03.2023**
(21) Application number: 21169747.9
(22) Date of filing: 21.04.2021
(51) Int. Cl.: C01B 32/194, H01L 21/027, B82Y 30/00, C23C 16/26, C23C 16/56, G03F 7/32, G03F 7/42

(54) **METHOD OF POLYMETHYLMETHACRYLATE (PMMA) REMOVAL FROM A GRAPHENE SURFACE BY PHOTOEXPOSURE**
VERFAHREN ZUR ENTFERNUNG VON POLYMETHYLMETHACRYLAT (PMMA) VON EINER GRAPHENOBERFLÄCHE DURCH PHOTOBELICHTUNG
PROCÉDÉ D'ÉLIMINATION DE POLYMÉTHACRYLATE DE MÉTHYLE (PMMA) D'UNE SURFACE DE GRAPHÈNE PAR PHOTOEXPOSITION

(30) Priority: 08.07.2020 LT 2020535
(43) Date of publication of application: 12.01.2022
(73) Proprietor: Valstybinis Moksliniu Tyrimu Institutas Fiziniu Ir Technologijos Mokslu Centras, 02300 Vilnius (LT)
(72) Inventor: ALEXEEVA, Natalia, 10257 Vilnius (LT); KASALYNAS, Irmantas, 10257 Vilnius (LT)
(74) Representative: Draugeliene, Virgina Adolfina

(56) References cited:
- CN-B- 102 849 732
- SUHAIL A ET AL: "Reduction of polymer residue on wet-transferred CVD graphene surface by deep UV exposure", APPLIED PHYSICS LETTERS, A I P PUBLISHING LLC, US, vol. 110, no. 18, 4 May 2017 (2017-05-04), XP012218603, ISSN: 0003-6951, DOI: 10.1063/1.4983185 [retrieved on 2017-05-04]
- YANG XIAOJIAN ET AL: "Removing contaminants from transferred CVD graphene", NANO RESEARCH, TSINGHUA UNIVERSITY PRESS, CN, vol. 13, no. 3, 14 February 2020 (2020-02-14), pages 599-610, XP037271023, ISSN: 1998-0124, DOI: 10.1007/S12274-020-2671-6 [retrieved on 2020-02-14]
- JEONG HEE JIN ET AL: "Improved transfer of chemical-vapor-deposited graphene through modification of intermolecular interactions and solubility of poly(methylmethacrylate) layers", CARBON, ELSEVIER OXFORD, GB, vol. 66, 29 September 2013 (2013-09-29), pages 612-618, XP028758983, ISSN: 0008-6223, DOI: 10.1016/J.CARBON.2013.09.050
- KIM JIN HONG ET AL: "Facile Dry Surface Cleaning of Graphene by UV Treatment", JOURNAL OF THE KOREAN PHYSICAL SOCIETY, KOREAN PHYSICAL SOCIETY, KR, vol. 72, no. 9, 28 April 2018 (2018-04-28) , pages 1045-1051, XP036490371, ISSN: 0374-4884, DOI: 10.3938/JKPS.72.1045 [retrieved on 2018-04-28]

## Description

### Field of the invention

The method relates to the technical field of material science, in particular the invention discloses a method of PMMA layer removal from a surface of graphene which is located on a substrate by means of deep ultraviolet (DUV) photoexposing and developing.

### Background of the invention

There is a high demand for circuits and devices based on graphene (a novel 2D semiconductor material comprising a single layer of carbon) due to its unique properties making graphene an ideal candidate for future electronics applications. For different purposes (CVD graphene transfer or patterning) polymer polymethyl methacrylate (PMMA) is in use to coat graphene.

After graphene has been transferred or patterned, PMMA traditionally is dissolved by immersing it in a wide variety of organic solvents, such as acetone, toluene, xylene, di- and trichloromethane, chlorobenzene, ethyl lactate, ethyl acetate etc, that often are toxic and carcinogenic. After treatment in solvents, graphene requires further annealing in Ar flow for several hours to clean residuals (resin and solvents) which presence modifies physical properties of graphene, for example, conductivity change due to graphene doping.

In e-beam lithography there is another way to dissolve polymer (PMMA), here used as the resist material for patterning of very small structures in the resist with sub-10 nm resolution. E-beam lithography is the process of scanning a focused beam of electrons across a resist layer and thereby creating a pattern. The electron beam changes the solubility of the resist, enabling selective removal of either the exposed or non-exposed regions of the resist by developing (immersing PMMA in a solvent). There is a number of related solvents and solvent mixtures. Development process characterization of alcohol/water mixtures, namely ethanol and isopropanol mixtures with water [L. Ocola, M. Costales and D Gosztola, Development characteristics of PMMA in alcohol/water mixtures: a lithography and Raman spectroscopy study. Nanotechnology 27 (2016) p.035302], demonstrates the advantages of such mixtures over commercially available developers (as methyl isobutyl ketone (MIBK), "LIGA" mixtures). Although isopropanol/water mixture looks promising solvent for graphene cleaning as not introducing additional residuals, the fundamental feature of e-beam lithography as especially designed for selective removal of PMMA limits its potential utilizing for graphene cleaning.

Recent work [A. Suhail, K. Islam, B. Li, et al. Reduction of polymer residue on wet-transferred CVD graphene surface by deep UV exposure. Applied Physics Letters 110 (2017) p. 183103] described in detail a process of the graphene production on a copper foil by a CVD process, the subsequent coating of a PMMA layer onto the graphene/copper foil to form a PMMA/graphene/copper structure, the subsequent removal of the copper foil by wet-etching so that a PMMA/graphene structure remains, the wet transfer of the PMMA/graphene structure onto a SiO2/Si substrate so that a PMMA/graphene/SiO2/Si structure is formed, and the subsequent removal of the PMMA layer by the following procedure steps: (i) irradiation of the PMMA of the PMMA/graphene/SiO2/Si structure with DUV wavelength of 254 nm light; (ii) treatment of the PMMA/graphene/SiO2/Si structure with an acetone solution to dissolve and remove the irradiated PMMA; (iii) cleaning of the graphene/SiO2/Si structure with a mixture of isopropanol/deionized water, (iv) and drying of the graphene/SiO2/Si structure in vacuum atmosphere.

Removal of contaminants, notably of the PMMA transfer film from transferred CVD graphene layers, was investigated in the work [X. Yang and M. Yan, Removing contaminants from transferred CVD graphene. Nano Research 13 (2020) pp. 599-610]. Here numerous techniques for reducing the amount of contaminants onto transferred graphene layers whereas a PMMA film used as the support material were described. As classic transfer method is described the removal of the PMMA layer in an acetone bath after the graphene layer has been transferred onto a target substrate. Variety of different methods to minimize PMMA and other residuals on transferred CVD graphene layers were also discussed. Amongst others, the pretreatment of the PMMA film with UV radiation before stripping off the PMMA in a solvent was mentioned. The degradation of the PMMA film by photons of DUV light (254 nm wavelength) followed by a removal in a solvent solution (in most cases acetone) is described in detail.

An improved transfer of CVD graphene through modification of intermolecular interactions and solubility of PMMA layers was disclosed in the work [H. J. Jeong, H. Y. Kim, S. Y. Jeong, J. T. Han, K. J. Baeg, J. Y. Hwang, and G. W. Lee, Improved transfer of chemical-vapor-deposited graphene through modification of intermolecular interactions and solubility of poly (methylmethacrylate) layers. Carbon 66 (2014) pp. 612-618]. The authors proposed the coating of a 1st PMMA layer onto a graphene layer deposited onto a copper film, the DUV irradiation (256 nm light) of the 1st PMMA layer, the subsequent coating of a 2nd sacrificial PMMA layer onto the 1st PMMA layer, the etching of the cupper film, the transfer of the graphene layer together with two PMMA layers onto a target substrate, and the cleaning of the UV-irradiated PMMA layer using a mixture of isopropyl alcohol (IPA), acetone and MIBK.

A method of facile dry surface cleaning of graphene containing PMMA residuals by DUV treatment was introduced in the work [J. H. Kim, M. M. Haidari, J. S. Choi, H. Kim, Y. J. Yu, and J. Park, Facile Dry Surface Cleaning of Graphene by UV Treatment. Journal of the Korean Physical Society 72 (2018) pp. 1045-1051]. After the wet transfer of the graphene monolayer with coating of PMMA onto a SiO2 substrate, the UV-C irradiation from a Xe lamp was used for PMMA residue removal under atmospheric condition by controlling the irradiation time. In this method, UV irradiation was used to create an excited state in the molecular bonds of the polymer and reactive oxygen species. The reaction between these oxygen species and excited polymers results in decomposition of long chains to shorter ones, which easily desorb from the graphene surface during an additional thermal annealing process.

Chinese Patent application CN106647183A, published on 2017-05-10, describes the photoetching method of graphene device, via usage of the DUV source instead of e-beam. It allows to expose the whole area of PMMA on graphene. After an exposing through the lithography mask, the PMMA areas were developed with the developer mixture such as methyl isobutyl ketone (MIBK) and isopropanol (IPA) to dissolve exposed areas releasing a pattern. Then, graphene is washed with isopropanol solution and deionized water.

In this method indicated that the HgXe lamp is used as a source of deep ultraviolet light, which generate light in the range from 180 nm to 400 nm. The photolithographically photographed graphene was developed using a MIBK and IPA in which the volume ratio of methyl isobutyl ketone and isopropanol was 1: 4 and the developing time was 3 minutes. The developer used for PMMA removal introduces residuals which modify graphene properties.

The closest analogue, Chinese Patent application CN107867683A, published on 2018-04-03, describes a large area and high quality graphene transfer method in which DUV source is used to expose PMMA on graphene for 1-3 hours without the lithographic mask for purpose of PMMA removal from graphene surface.

With DUV photo-exposure PMMA experiences cleavage, which facilitate the removal process. The exposed PMMA was dissolved by acetone vapor. Finally, the graphene was immersed in anhydrous ethanol and deionized water, respectively, and dry nitrogen was blown to obtain a graphene film.

This method does not take full advantage of the photo-sensitivity properties of PMMA and its removal in solvents is not efficient enough. In addition, the method has more operations because after solvent steam cleaning, a two-step wash with anhydrous ethanol and deionized water is required, making it more complex and requiring more materials.

### Technical problem to be solved

The invention aims to provide effective, reliable, accessible, and easy to use PMMA removal method for cleaning graphene without changing its properties.

### Disclosure of invention

In order to solve the above problem in the method of a polymethylmethacrylate (PMMA) layer removal from a graphene surface, wherein the PMMA layer covers the graphene layer located on a substrate, comprising:
- subjecting the PMMA layer to deep ultraviolet (DUV) light irradiation, to facilitate the removal of the PMMA layer from the graphene surface;
- treating the irradiated PMMA layer in order to remove the PMMA layer from the graphene surface;
- drying the cleaned graphene layer located on the substrate in a stream of nitrogen gas, wherein the irradiation is performed by photo-exposure of the PMMA layer with the UV-C band source, and
the treatment is performed by a development of the photoexposed PMMA layer in an alcohol/deionized water mixture.

Whole area of the PMMA layer is photoexposed for 2-6 hours, depending on the layer thickness, with the low-pressure mercury vapour lamp with the emission spectrum in the range of 100-280 nm, with a peak at λ=253.7 nm.

The photoexposed PMMA layer is developed in the alcohol/water mixture which can be selected from a group consisting of the following mixtures: methanol/water, ethanol/water, isopropanol/water.

The photoexposed PMMA layer is developed in isopropanol/water mixture having an isopropanol/water volume ratio in a range of 70:30 to 75:25.

### Advantages of the invention

The proposed method of PMMA removal from the surface of graphene improves the cleaning efficiency, as it does not impact the properties of graphene cleaned, uses a mixture of isopropanol and deionized water for development, developer acts as a solvent that rapidly dissolves the photoexposed PMMA polymer, no hazard chemicals (toxic or carcinogenic) are being used, no additional washing is required after development. The cleaning technology is simple, after which thermal annealing of graphene is not needed. A low-pressure mercury vapor lamp is used as a source of UV-C spectrum, which is inexpensive, easy to use and maintain.

### Brief description of drawings

Fig.1 shows the initial PMMA/graphene/target substrate.
Fig.2 shows the PMMA/graphene/target substrate subjected to DUV.
Fig.3 shows the PMMA/graphene/target substrate subjected to developer alcohol/water.
Fig.4 shows graphene/target substrate after PMMA developed and removed.
Fig.5 represents the optical image of graphene/target substrate SiO2 after PMMA removal by this method.
Fig.6 represents Raman spectrum of graphene after PMMA removal by this method.

### Detailed description of the invention

For the proposed method of realization, the substrate may be selected from materials such as silicon, silicon dioxide, sapphire, or silicon carbide with a graphene layer that has been coated with PMMA resin. Said layers PMMA/graphene/substrate may be the result of, for example, the transfer of wet graphene from a Cu foil on which graphene is grown as a substrate, or structuring in the manufacture of graphene devices when PMMA is used as a mask layer.

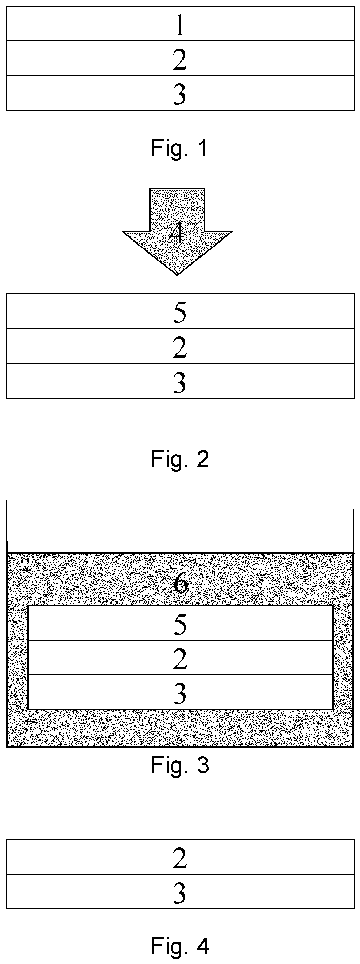

Figure 1 shows a 60 nm thick PMMA layer 1 which covers a graphene layer 2, transferred onto selected substrate 3. In this case, a commercial CVD graphene coated with a 60 nm thick 495 K molecular weight PMMA layer was used. The method was also tested with a different thickness of 950 K molecular weight PMMA used for the wet transfer of graphene from copper foil, which is used as a substrate during graphene synthesis.

Figure 2 shows a layered PMMA/graphene/substrate in which PMMA layer 1 is subjected to DUV radiation 4 for two hours until an exposed PMMA layer 5 is formed. The PMMA exposure was performed using a non-collimated DUV radiation source (Crosslinker XL-1000) equipped with low pressure mercury vapour ultraviolet lamps (Philips T5 Germicidal UV-C) which radiation is the range from 100 nm till 280 nm with the strongest peak in the emission spectrum at 254 nm. In photo exposed areas, the exposure dose induces scission resulting in formation of short chains in the polymer that dissolve significantly faster compared to long chains in the polymer.

After exposure the layered sample PMMA/graphene/substrate, shown in Fig. 3, is immersed in the developer, where the exposed PMMA layer 5 is developed in the IPA: H2O (7: 3) mixture for 30 seconds.

Figure 4 shows graphene/substrate after the PMMA layer 5 has been removed from the graphene layer 2. The graphene/substrate is then dried by a stream of nitrogen gas.

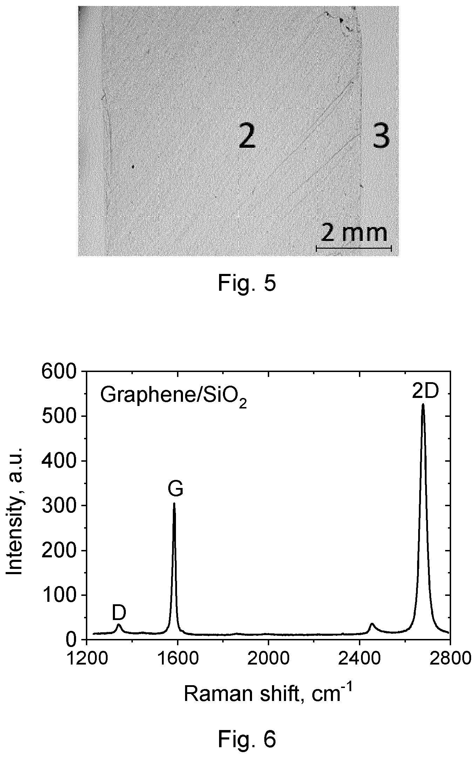

Figure 5 shows a photograph of an optical microscope (Hirox 3D Digital Microscope) of the graphene layer 2 transferred from the Cu foil on the SiO2 substrate 3 after the PMMA layer was removed from the graphene by proposed method, revealing very clean surface of the graphene 2 without noticeable residuals of PMMA.

Figure 6 shows the Raman spectrum of graphene from which PMMA was removed by proposed method. Spectroscopic measurements were performed using a Raman spectrometer using a green laser (λ = 532 nm) and a grid of 1800 g/mm. The observed spectrum was measured using 5% power, integration time T = 100 s, at the main line v₀ = 2050 cm⁻¹. The main lines shown in the figure are characteristic of the single-layer graphene spectrum.

The photosensitive properties of PMMA are utilized in the proposed method, based on the fact that PMMA is a well-known resist for nano-lithography with the exposure systems using short UV wavelengths (<260 nm) for scission of polymer chains. In this case exposure dose leads to shorter PMMA fragments in the exposed area. Short PMMA fragments dissolve more quickly than longer ones. Exposure systems used for this purpose are based on electromagnetic DUV radiation source equipped with low-pressure mercury vapour ultraviolet lamps which have no limitation on the size of exposed area of resist. Also such sources are low cost and easy to use and maintain. The strongest peak in the emission spectrum of these lamps is located at 254 nm while their radiation is non-collimated and can be used to expose either large or small areas required for PMMA removal from graphene.

To develop the exposed PMMA we use alcohol/water mixture both utilizing its excellent properties as a developer with enhanced dissolution rate and avoiding residuals introduction on a surface of graphene (as IPA is inherent/natural for graphene processing). In addition, water/alcohol mixtures are non-toxic. [see for example S. Yasin, D.G. Hasko, H. Ahmed, Comparison of MIBK/ IPA and water/IPA as PMMA developers for electron beam nanolithography. Microelectronic Engineering 61-62 (2002) pp.745-753]. Since both IPA/ethanol and water separately are non-solvents for PMMA at room temperature, this mixture acts as a cosolvent system providing high rate of solubilisation of a polymer.

## Claims

1. Method of a polymethylmethacrylate (PMMA) layer removal from a graphene surface, wherein the PMMA layer covers a graphene layer located on a substrate, comprising:
- subjecting the PMMA layer to deep ultraviolet (DUV) light irradiation, to facilitate the removal of the PMMA layer from the graphene surface;
- treating the irradiated PMMA layer in order to remove the PMMA layer from the graphene surface;
- drying the cleaned graphene layer located on the substrate in a stream of nitrogen gas,
whereas the irradiation is performed by photo-exposure of the PMMA layer with a UV-C band source, and
the treatment is performed by a development of the photoexposed PMMA layer in an alcohol/deionized water mixture.

2. Method according to claim 1, whereas the whole area of the PMMA layer is photoexposed for 2-6 hours, depending on the layer thickness, with a low-pressure mercury vapour lamp with an emission spectrum in the range of 100-280 nm, with a peak at λ=253.7 nm.

3. Method according to claim 1 or 2, whereas the photoexposed PMMA layer is developed in the alcohol/deionized water mixture which is selected from a group consisting of the following mixtures: methanol/water, ethanol/water, isopropanol/water.

4. Method according to claim 3, whereas the photoexposed PMMA layer is developed in an isopropanol/water mixture having an isopropanol/water volume ratio in a range of 70:30 to 75:25.

## Patentansprüche

1. Verfahren zum Entfernen von Polymethylmethacrylat (PMMA) von einer Graphenoberfläche, wobei die PMMA-Schicht eine auf einem Substrat befindliche Graphenschicht bedeckt, umfassend:
- Aussetzen der PMMA-Schicht einer Bestrahlung mit tiefem Ultraviolettlicht (DUV), um das Entfernen der PMMA-Schicht von der Graphenoberfläche zu erleichtern;
- Behandeln die bestrahlten PMMA-Schicht, um die PMMA-Schicht von der Graphemoberfläche zu entfernen;
- Trocknen die gereinigten Graphemschicht, die sich auf die Substrat befindet, in einem Stickstoffgasstrom, wobei
die Bestrahlung erfolgt durch eine Fotobelichtung der PMMA-Schicht mit einer UV-C-Bandquelle, und
die Behandlung wird durch eine Entwicklung der fotoexponierten PMMA-Schicht in einer Alkohol/deionisierten Wasser-Mischung durchgeführt.

2. Verfahren nach Anspruch 1, wobei die PMMA-Schicht ganzflächig je nach Schichtdicke 2-6 Stunden mit einer Niederdruck-Quecksilberdampflampe mit einem Emissionsspektrum im Bereich von 100-280 nm photobelichtet wird , mit einem Peak bei λ=253,7 nm.

3. Verfahren nach Anspruch 1 oder 2, wobei die photobelichtete PMMA-Schicht in dem Alkohol/deionised Wasser-Mischung entwickelt wird, das aus einer Gruppe ausgewählt ist, die aus folgenden Gemischen besteht: Methanol/Wasser, Ethanol/Wasser, Isopropanol/Wasser.

4. Verfahren nach Anspruch 3, wobei die fotobelichtete PMMA-Schicht in einem Isopropanol/Wasser-Gemisch mit einem Isopropanol/Wasser-Volumenverhältnis im Bereich von 70:30 bis 75:25 entwickelt wird.

## Revendications

1. Procédé d'élimination d'un polyméthacrylate de méthyle (PMMA) d'une surface de graphène, où la couche de PMMA recouvre une couche de graphène située sur un substrat, comprenant :
- soumettre la couche de PMMA à une irradiation de lumière ultraviolette profonde (DUV), pour faciliter le retrait de la couche de PMMA de la surface de graphène ;
- traiter la couche de PMMA irradiée afin d'éliminer la couche de PMMA de la surface du graphème ;
- sécher la couche de graphème nettoyée située sur le substrat dans un courant d'azote gazeux,
dans lequel
l'irradiation est réalisée par photo-exposition de la couche de PMMA avec un source de bande UV-C, et
le traitement est réalisé par un développement la couche de PMMA photoexposée dans un mélange alcool/eau déminéralisée.

2. Procédé selon la revendication 1, dans lequel toute la surface de la couche de PMMA est photoexposée pendant 2 à 6 heures, en fonction de l'épaisseur de la couche, avec un lampe à vapeur de mercure à basse pression avec un spectre d'émission dans la plage de 100 à 280 nm. , avec un pic à λ = 253,7 nm.

3. Procédé selon la revendication 1 ou 2, dans lequel la couche de PMMA photoexposée étant développée dans le mélange alcool/eau désionisée qui est choisi dans un groupe constitué des mélanges suivants: méthanol/eau, éthanol/eau, isopropanol/eau.

4. Procédé selon la revendication 3, dans lequel la couche de PMMA photoexposée est développée dans un mélange isopropanol/eau ayant un rapport volumique isopropanol/eau compris entre 70/30 et 75/25.
